# NEUE EUROPÄISCHE PATENTSCHRIFT

(11) **EP 0 330 062 B2**
(45) Veröffentlichungstag und Bekanntmachung des Hinweises auf die Entscheidung über den Einspruch: **16.08.2000**
(45) Hinweis auf die Patenterteilung: 30.09.1992
(21) Anmeldenummer: 89102560.3
(22) Anmeldetag: 15.02.1989
(51) Int. Cl.: H03G 3/00, H03G 5/00, G08G 1/09

(54) **Rundfunkempfänger für ein Fahrzeug**
Radio receiver for a vehicle
Récepteur radiophonique pour un véhicule

(30) Priorität: 22.02.1988 DE 3805457
(43) Veröffentlichungstag der Anmeldung: 30.08.1989
(73) Patentinhaber: Deutsche Thomson-Brandt GmbH, 78003 Villingen-Schwenningen (DE)
(72) Erfinder: Kluth, Hans-Jürgen Dipl.-Ing., D-7730 VS-Villingen (DE)

(56) Entgegenhaltungen:
- DE-A- 2 716 564
- DE-A- 3 045 722
- GRUNDIG TECHNISCHE INFORMATIONEN, Band 29, Nr. 6, 1982, Seiten 258-263, Regensburg, DE; H. SINNING: "WKC 3867 VD, Verkehrsrundfunkdekoder, vollelektronische Störaustastung und Klangsteller"

## Beschreibung

Die vorliegende Erfindung betrifft einen Rundfunkempfänger für ein Fahrzeug, mit einer Einrichtung zum automatischen Umschalten der Wiedergabelautstärke auf einen voreingestellten Wert in Abhängigkeit von einem nur im Zusammenhang mit einer Verkehrsfunkdurchsage ausgestrahlten Kennsignal.

Bestimmte UKW-Rundfunksender senden zu bestimmten Zeiten oder aus gegebenem Anlaß Verkehrsfunkdurchsagen, um insbesondere die Fahrer von Kraftfahrzeugen auf Behinderungen, Erschwernisse, Umleitungen oder Gefahrenpunkte aufmerksam zu machen. Bei dem System ARI ist es bekannt, mit einem senderseitig ausgestrahlten Pilotsignal den an sich ausgeschalteten Empfänger einzuschalten, eine laufende Kassetten-Wiedergabe abzuschalten oder die jeweils eingestellte Lautstärke auf einen für die Verständlichkeit optimalen Wert umzuschalten, insbesondere zu erhöhen, damit z.B. der Fahrer bei einer relativ leisen Musikwiedergabe die Verkehrsfunkdurchsage nicht überhört und aufmerksam gemacht wird.

Aus der DE-A-27 16 546 ist ein Empfänger der eingangs genannten Art bekannt, bei dem in Abhängigkeit von dem Kennsignal die Lautstärke zwangsweise umgeschaltet wird.

Es hat sich in der Praxis gezeigt, daß unmittelbar nach der Umschaltung die Verkehrsfunkdurchsage durch den Fahrer als unangenehm empfunden wird, oftmals akustisch schwer verständlich ist und sogar durch die plötzlich erhöhte Lautstärke den Fahrer erschrecken kann.

Aus der DE-A-30 45 722 ist ein Rundfunkempfänger bekannt, bei dem eine Umschaltung von Wiedergabeparametern in Abhängigkeit von einem Programmartsignal erfolgt. Dadurch soll eine senderseitige Vollaussteuerung ermöglicht sein, wobei gleichzeitig auf der Empfängerseite der individuelle Geschmack nicht vernachlässigt zu werden brauche. Besondere Maßnahmen hinsichtlich besserer Verständlichkeit von Verkehrsdurchsagen sind nicht vorgesehen und auch nicht erkannt.

Der Erfindung liegt die Aufgabe zugrunde, einen Rundfunkempfänger für ein Fahrzeug so auszubilden, daß einerseits die Sprachdurchsage nach der erfolgten Umschaltung subjektiv angenehmer und verständlicher ist und andererseits daß beim Umschalten der Lautstärke, insbesondere bei der Erhöhung der Lautstärke, vermieden wird, daß die Wiedergabe der Verkehrsfunkdurchsagen zu Beginn zu unangenehm ist und ein Knacken auftritt.

Diese Aufgabe wird durch die im Anspruch 1 beschriebene Erfindung gelöst. Vorteilhafte Weiterbildungen der Erfindung sind in den Unteransprüchen beschrieben.

Die Erfindung beruht auf folgender Erkenntnis. Fahrzeuge wie Autos haben heute in zunehmendem Maße sehr hochwertige HiFi-Rundfunkanlagen mit Stereo-Kassettenrecorder und einer Mehrzahl von Lautsprechern. Dadurch kann durch entsprechende Anhebung der Tiefen und Höhen, die meist subjektiv als angenehm empfunden wird, eine angenehme HiFi-Tonwiedergabe erfolgen. Bei der Sprachwiedergabe indessen ist gerade diese Einstellung im allgemeinen nachteilig, insbesondere wegen der stark angehobenen Tiefen. Die Sprache klingt dann oft zu dumpf und wird unverständlich. Wenn jetzt bei Umschaltung auf Verkehrsfunkdurchsage die Tiefen und Höhen durch Umschaltung des NF-Frequenzganges auf einen für den jeweiligen Fahrer subjektiv optimalen Wert umgeschaltet werden, wird diese Durchsage für ihn angenehmer und verständlicher. Der Fahrer braucht dann auch nicht bei Beginn der Verkehrsfunkdurchsage manuell die Tiefen und Höhen zurückzudrehen. Durch die erfindungsgemäße Maßnahme wird also insgesamt die Verkehrsfunkdurchsage für den Fahrer angenehmer und die Verkehrssicherheit erhöht. Erfindungsgemäß erfolgt die Umschaltung der Tiefen und Höhen zeitlich kurz vor der Umschaltung, insbesondere Erhöhung der Lautstärke, z.B. in der Größenordnung von 100 ms vorher. Dadurch wird vermieden, daß die Wiedergabe der Verkehrsfunkdurchsage zu Beginn noch zu unangenehm ist und ein Knacken auftritt.

Gemäß einer Weiterbildung der Erfindung erfolgt bei der Umschaltung der Lautstärke zusätzlich in Abhängigkeit von dem Kennsignal eine automatische Umschaltung der Tiefen und Höhen der wiedergegebenen Verkehrsfunkdurchsage auf voreingestellte Werte, dahingehend, daß der NF-Frequenzgang der wiedergegebenen Verkehrsfunkdurchsage einen im wesentlichen linearen Verlauf aufweist.

Bei der genannten Umschaltung können ggf. weitere Umschaltungen im Fahrzeug durchgeführt werden, die für die Aufmerksamkeit des Fahrers vorteilhaft sind, z.B. die Abschaltung akustisch störender Verbraucher wie z.B. Gebläse. Es kann auch zweckmäßig sein, bei der Umschaltung in einem Auto die Hecklautsprecher abzuschalten, da dann die wiedergegebene Information im wesentlichen nur für den Fahrer bestimmt ist und es nur auf die Verständlichkeit und nicht auf eine HiFi-Wiedergabe ankommt.

Die Erfindung wird im folgenden anhand der Zeichnung an einem Ausführungsbeispiel erläutert Darin zeigen
Fig. 1 ein Blockschaltbild des erfindungsgemäßen Empfängers,
Fig. 2,3 Kurven zur Erläuterung der Wirkungsweise.

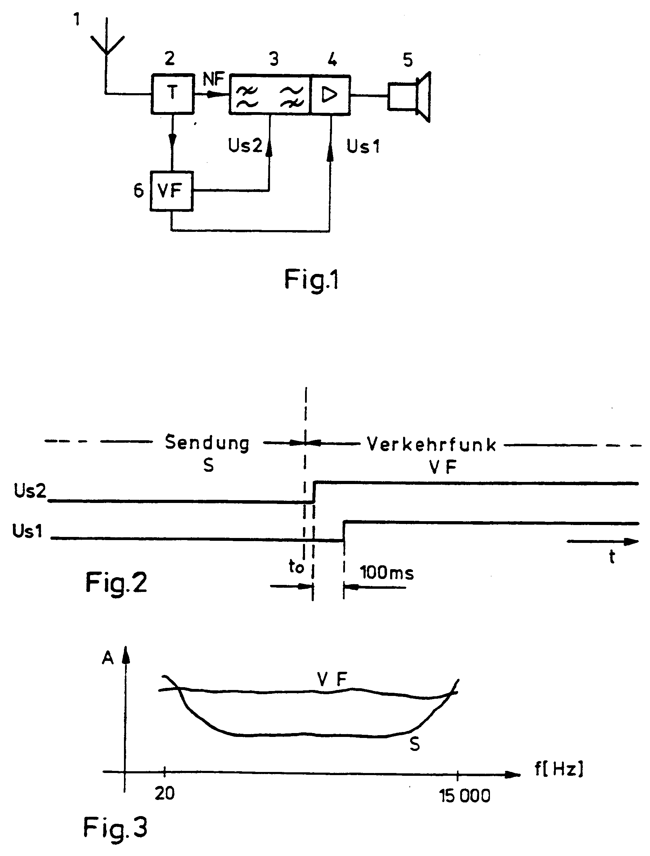

Fig. 1 zeigt einen Empfänger für ein Kraftfahrzeug. Das mit der Antenne 1 empfangene UKW-Signal gelangt auf den Tuner 2, der das NF-Tonsignal für die Tonwiedergabe liefert. Das NF-Tonsignal gelangt über die Schaltung 3 zur Anhebung der Tiefen und Höhen und den Endverstärker 4 auf den Lautsprecher 5. Das Signal des Tuners 2 gelangt außerdem an den Verkehrsfunk-Decoder 6. Dieser Decoder erkennt das während einer Verkehrsfunkdurchsage vom Sender gesendete Pilotsignal und liefert eine Stellgröße Us1, die im Verstärker 4 die Wiedergabe der Lautstärke auf einen voreingestellten Wert erhöht und ggf. andere störende Verbraucher wie Kassettenrecorder, Geblase abschaltet.

Der Decoder 6 erzeugt zusätzlich die Schaltspannung Us2. Diese Schaltspannung schaltet in der Schaltung 3 die Tiefen und Höhen auf Werte um, die für die reine Sprachverständlichkeit optimal sind. Diese Werte sind vorzugsweise einstellbar, weil erfahrungsgemäß der optimale NF-Frequenzgang für eine optimale Sprachverständlichkeit sehr individuell ist.

Fig. 2 zeigt den zeitlichen Verlauf der beiden Schaltspannungen Us1 und Us2. Mit to ist der Beginn einer Verkehrsfunkdurchsage (VF) bezeichnet. Zu diesem Zeitpunkt erfolgt also die Umschaltung von einer normal laufenden Rundfunksendung S auf Verkehrsfunk VF. Kurz danach erscheint die Schaltspannung Us2 und schaltet die Tiefen und Höhen auf für die Sprachverständlichkeit optimale Werte um. Etwa 100 ms später erscheint die Schaltspannung Us1 und schaltet die Lautstärke auf einen festeingestellten, für die Verständlichkeit optimalen Wert um. Dieser Wert ist im wesentlichen von der Größe des Kraftfahrzeuges, dem Motorgeräusch und dem Fahrgeräusch abhängig.

Fig. 3 zeigt die unterschiedlichen Frequenzgänge bei normaler Rundfunksendung S und Verkehrsfunkdurchsage VF. Bei einer Rundfunksendung oder auch einer Kassettenwiedergabe ist im allgemeinen der Frequenzgang zu tiefen Frequenzen und zu hohen Frequenzen hin stark angehoben, weil dadurch eine subjektiv angenehmere Wiedergabe erfolgt. Bei Verkehrsfunkdurchsage VF indessen ist einerseits die Wiedergabelautstärke erhöht und andererseits durch die Schaltspannung Us2 der Frequenzgang auf einen annähernd linearen Verlauf mit konstantem NF-Pegel und konstantem Schaltungspegel über den ganzen Hörfrequenzbereich umgeschaltet.

## Patentansprüche

1. Rundfunkempfänger für ein Fahrzeug, mit einer Einrichtung zum automatischen Umschalten der Wiedergabelautstärke auf einen voreingestellten Wert in Abhängigkeit von einem nur im Zusammenhang mit einer Verkehrsfunkdurchsage ausgestrahlten Kennsignal, dadurch gekennzeichnet, daß zeitlich kurz vor der Umschaltung der Lautstärke zusätzlich in Abhängigkeit von dem Kennsignal eine automatische Umschaltung der Tiefen und Höhen der wiedergegebenen Verkehrsfunkdurchsage auf, voreinstellbare oder voreingestellte Werte erfolgt,
wobei die Zeitspanne zwischen den Umschaltungen so gewählt ist, daß ein Knacken zu Beginn der Verkehrsfunkdurchsage vermieden wird.

2. Empfänger nach Anspruch 1 dadurch gekennzeichnet, daß nach der Umschaltung der Tiefen und Höhen der NF-Frequenzgang der wiedergegebenen Verkehrsfunkdurchsage einen im wesentlichen linearen Verlauf aufweist.

3. Empfänger nach Anspruch 1 oder 2, dadurch gekennzeichnet, daß in einem Auto bei der Umschaltung die Hecklautsprecher abgeschaltet werden.

4. Empfänger nach Anspruch 1 oder 2, dadurch gekennzeichnet, daß bei der Umschaltung automatisch andere störende Quellen wie z. B. Gebläse und Unterhaltungsgeräte abgeschaltet werden.

## Claims

1. Radio receiver for a vehicle, with a device for switching the playback volume over automatically to a preset value in dependence on an identification signal emitted only in connection with a radio traffic announcement,
characterized in that shortly before the volume is switched-over, the bass and treble tones of the reproduced radio traffic announcement are also switched-over automatically in dependence on the identification signal to values which can be, or have been, preset,
wherein the time period between said switching-over operations is chosen in such a way that a crackling noise at the beginning of the radio traffic announcement is avoided.

2. Receiver according to claim 1, characterized in that after the switching-over of the bass and treble tones the LF-frequency response of the reproduced radio traffic announcement has an essentially linear characteristic.

3. Receiver according to claim 1 or 2, characterized in that in a car the rear loudspeakers are turned off when the switchover takes place.

4. Receiver according to claim 1 or 2, characterized in that other sources of interference such as fans and entertainment equipment, for example, are turned off automatically when the switchover takes place.

## Revendications

1. Récepteur radiophonique pour un véhicule, avec un dispositif de commutation automatique de l'intensité sonore de la reproduction sur une valeur préréglée en fonction d'un signal d'identification émis uniquement en rapport avec une information radiodiffusée pour la circulation routière, **caractérisé en ce que** peu de temps avant la commutation de l'intensité sonore une commutation automatique des graves et des aigus de l'information radiodiffusée pour la circulation routière reproduite s'effectue en plus sur des valeurs préréglables ou préréglées, en fonction du signal d'identification, où l'intervalle de temps entre les commutations est choisi de sorte que l'on puisse éviter un grésillement au début de l'information radiodiffusée pour la circulation routière.

2. Récepteur conforme à la revendication 1, **caractérisé en ce que** la courbe de réponse basse fréquence de l'information radiodiffusée pour la circulation routière reproduite présente une allure essentiellement linéaire après la commutation des graves et des aigus.

3. Récepteur conforme à la revendication 1 ou 2, **caractérisé en ce que**, dans une automobile, les haut-parieurs arrières sont mis hors circuit lors de la commutation.

4. Récepteur conforme à la revendication 1 ou 2, **caractérisé en ce que** d'autres sources de perturbations telles que les ventilateurs et les appareils de divertissement sont automatiquement mis hors circuit lors de la commutation.
